Europäisches Patentamt

European Patent Office

Office européen des brevets

(11) Publication number: **0 430 168 A2**

## EUROPEAN PATENT APPLICATION

(21) Application number: 90122650.6

(22) Date of filing: 27.11.90

(51) Int. Cl.⁵: **H01L 21/225**, H01L 21/334, H01L 21/76, H01L 21/329

(30) Priority: 01.12.89 JP 313722/89

(43) Date of publication of application:
05.06.91 Bulletin 91/23

(84) Designated Contracting States:
**DE FR GB Bulletin 1A/D**

(71) Applicant: **SEIKO INSTRUMENTS INC.**
**31-1, Kameido 6-chome Koto-ku**
**Tokyo 136(JP)**

(72) Inventor: **Aoki, Kenji, c/o Seiko Instruments**
**Inc.**
**31-1, Kameido 6-chome, Koto-ku**
**Tokyo(JP)**
Inventor: **Akamine, Tadao, c/o Seiko**
**Instruments Inc.**
**31-1, Kameido 6-chome, Koto-ku**
**Tokyo(JP)**
Inventor: **Saito, Naoto, c/o Seiko Instruments**
**Inc.**
**31-1, Kameido 6-chome, Koto-ku**
**Tokyo(JP)**

(74) Representative: **Fleuchaus, Leo, Dipl.-Ing. et al**
**Melchiorstrasse 42**
**W-8000 München 71(DE)**

(54) Doping method of impurity into semiconductor trench wall.

(57) A trench is formed in a semiconductor substrate to provide therein an inner wall. An inert film is removed from the trench inner wall to expose an active surface. A source gas ccntaining an impurity is applied to the active surface to adsorb the impurity to thereby form thereon an impurity film. The substrate is annealed to diffuse the impurity into the inner wall to thereby dope the impurity.

EP 0 430 168 A2

# DOPING METHOD OF IMPURITY INTO SEMICONDUCTOR TRENCH WALL

## BACKGROUND OF THE INVENTION

The present invention relates to the method of doping an impurity into a side wall of trench or groove formed on a surface of a semiconductor substrate.

Conventionally, it is known that the semiconductor surface is formed with a trench, and a semiconductor resistive element or a semiconductor capacitive element is formed in the trench in order to improve integration density of the semiconductor device. Further, it is known that such trench is utilized to form a device isolation region. An impurity is diffused into side walls of a trench in order to form the semiconductor elements or device isolation region. Conventionally, such doping of impurity is carried out by ion implantation or so-called predeposition to the side walls.

However, the ion implantation is effected to accelerate impurity ions to implant the same, hence the doping is necessarily directional. Therefore, the ion implantation has drawbacks that the impurity cannot be doped into the entire area of the side walls in a trench with uniform density and uniform diffusion depth.

On the other hand, the conventional predeposition is effected by diffusing impurity through an inert film barrier such as silicon dioxide coated on the trench side walls, hence the predeposition has the drawbacks that it would be difficult to control the impurity density and diffusion depth.

## SUMMARY OF THE INVENTION

In view of the above noted drawbacks of the prior art, an object of the invention is to provide a new method of doping an impurity uniformly and continuously into side walls of the trench.

## BRIEF DESCRIPTION OF THE DRAWINGS

Figs. 1A-1D are a process step diagram showing the inventive impurity doping method;

Fig. 2 is a block diagram showing a processing apparatus for use in the impurity doping;

Fig. 3 is a graph showing a peak density change of the doped boron;

Figs. 4A-4E are a process step diagram showing the method of producing a trench resistive element;

Fig. 5 is a sectional view of another trench resistive element;

Figs. 6A-6E are a process step diagram showing the method of forming a trench device isolation region; and

Fig. 7 is a sectional diagram of a trench capacitive element.

## DETAILED DESCRIPTION OF THE INVENTION

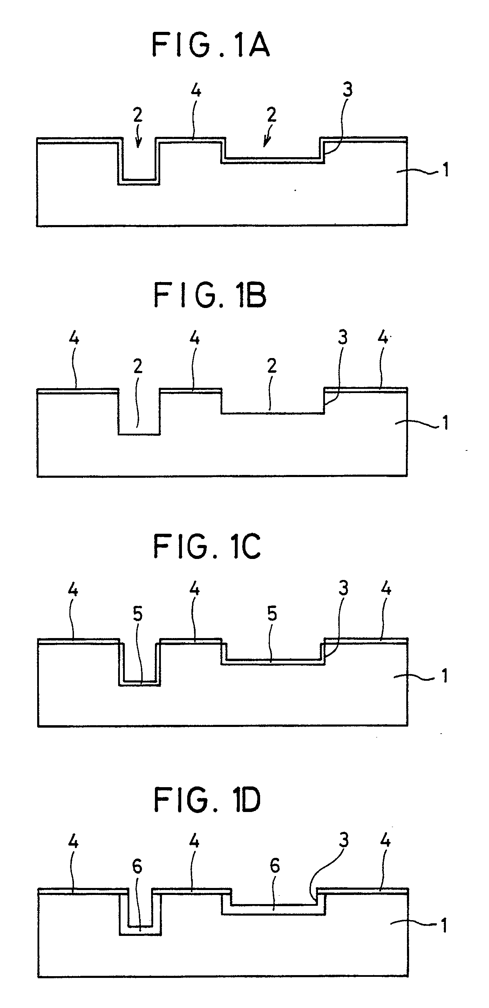

Figs. 1A-1D are a process step diagram showing the basic method of doping an impurity into a trench wall. In the Fig. 1A step, a semiconductor substrate 1 is formed thereon with a groove 2. The groove 2 is shaped, for example, in the form of a trench having an inner wall 3. The inner wall 3 includes side walls and bottom wall of the groove 2. The inner wall 3 is naturally covered with an inert film 4.

In the Fig. 1B step, the inert film is removed from a surface of the inner wall 3 to expose an active surface. In case that the semiconductor substrate 1 is composed of silicon, the inert film 4 is composed of a silicon oxide coating. The groove 2 or trench is generally formed by means of reactive ion etching. The inner wall 3 is immediately covered by an inert film after completion of the reactive ion etching treatment. Therefore, the Fig. 1B step is needed to clean the inner wall 3 of the groove 2 to expose an active surface. This cleaning treatment is carried out by heating the semiconductor substrate 1 in high vacuum condition. A reductive gas such as hydrogen may be concurrently introduced to facilitate the cleaning treatment.

In the Fig. 1C step, a source gas such as diborane which contains an impurity component in the form of boron atoms is applied to the exposed active surface so as to adsorb a compound composed of or containing the impurity component to form an impurity film 5. This adsorption treatment is carried out by introducing the diborane gas into a high vacuum chamber with a predetermined pressure. This impurity film 5 is selectively adsorbed substantially only onto the active surface.

Lastly in the Fig. 1D step, the semiconductor substrate 1 is heated so as to diffuse the impurity, i.e., boron which constitutes the impurity film 5 into the inner wall 3 and to activate the impurity. Consequently, the impurity diffusion layer 6 is formed along the inner wall 3. This impurity diffusion layer 6 has a desired electric conductivity and impurity diffusion density controlled by regulating an amount of the adsorbed impurity atoms and a heating time interval. Such impurity diffusion layer 6 can be utilized as a resistive layer, an electrode layer or an electrically isolating layer.

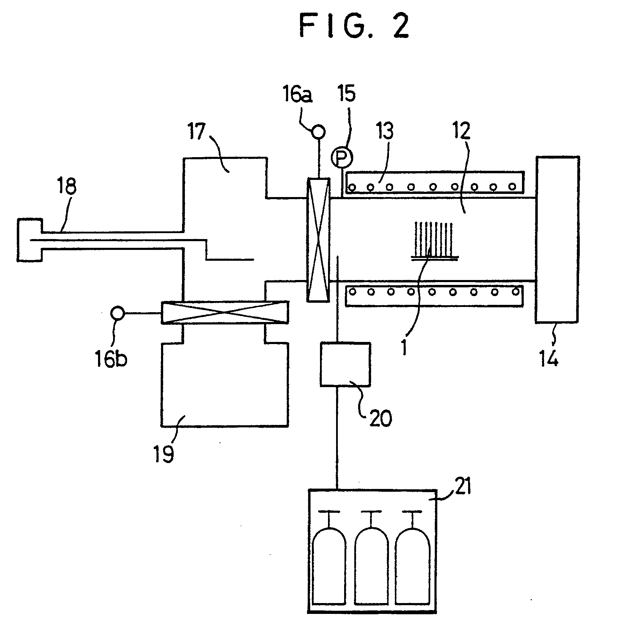

Fig. 2 is a block diagram showing a doping apparatus for practicing the impurity doping method according to the invention. As shown in the figure, the apparatus is comprised of a chamber 12 made of quartz, and a silicon substrate 1 is disposed in a central portion of the chamber 12. The silicon substrate 1 is formed with a trench beforehand, and the substrate 1 is covered by a mask over its surface except the trench inner wall. The substrate temperature is regulated by a heating system 13 utilizing an infrared ray lamp heater or a resistance heater so as to maintain the substrate temperature at a predetermined degree. The chamber 12 can be evacuated to high vacuum degree by means of an efficient vacuum system 14 composed of plural pumps including a main vacuum pump in the form of a turbo molecular pump. A vacuum degree of the chamber 12 is continuously monitored by a pressure gage 15. The silicon substrate 1 is transported by means of a transporting mechanism 18 to the chamber 12 from a loading chamber 17 which is connected to the chamber 12 through a gate value 16a which is held open during the transportation. The loading chamber 17 is normally evacuated by means of a loading chamber vacuum system 19 through an opened gate value 16b except when loading the silicon substrate 1 into the loading chamber 17 and transporting the same from the loading chamber 17. A gas supply source 21 is connected to the chamber 12 through a gas flow control system 20. The gas supply source 21 contains a plurality of bottles for storing various gas materials needed for doping of the impurity. The gas species, charging pressure and application time interval can be controlled by the gas flow control system 20 when charging gases from the supply source 21 to the chamber 12.

Next, the detailed description is given for processing steps of doping an impurity in the form of boron into an inner wall of a trench formed on the surface of the silicon substrate 1 with using the doping apparatus shown in Fig. 2. Firstly, the cleaning treatment is carried out for the inner wall 3 of the trench 2 formed on the silicon substrate 1. Namely, the silicon substrate 1 is placed in a central portion of the vacuum chamber 12 maintained below $1 \times 10^{-4}$ Pa of the background pressure. Then, the silicon substrate 1 is heated to 850° C, and hydrogen gas is introduced for a predetermined period into the chamber 12 under the condition that the chamber pressure is raised to $1.3 \times 10^{-2}$ Pa. By this treatment, the natural oxide film 4 is removed from the inner wall 3 formed in the silicon substrate surface to expose a chemically active surface. Subsequently, the activated inner wall is deposited with an adsorption layer composed of boron element or compound containing boron atoms. Namely, after completion of the inner wall cleaning, the hydrogen gas is stopped and the substrate temperature is lowered to, for example, 800° C. After reaching stably that target temperature, the chamber 12 is filled with diborane ($B_2H_6$)gas which contains boron and is dilluted to 5% with nitrogen carrier gas for a predetermined time interval under the chamber pressure condition of $1.3 \times 10^{-2}$ Pa. Consequently, an adsorption layer composed of boron element or boron-containing compound is deposited on the activated inner wall 3 of the groove formed on the silicon substrate 1. Concurrently with the formation of the adsorption layer of boron element or boron-containing compound, a part of boron atoms may be diffused into the bulk of silicon substrate 1 by a certain rate determined according to the substrate temperature and diborane gas pressure during the charging of the diborane. Then, heating treatment or annealing is carried out for the silicon substrate 1.

Namely, after adsorbing the boron impurity film 5 on the inner wall 3, the diborane gas is stopped and the substrate is heated for a predetermined time in the vacuum chamber 12. At this stage, the substrate temperature may be preferably set slightly higher than that during the impurity adsorption treatment. By this annealing treatment, the impurity diffusion layer 6 is formed along the inner wall 3 from a diffusion source composed of the boron impurity film 5, and concurrently the diffused boron atoms are partly activated. In the inventive method, the amount of adsorbed boron and the annealing condition (substrate temperature and heating interval) may be controlled to form an impurity diffusion layer having a desired impurity concentration and diffusion depth.

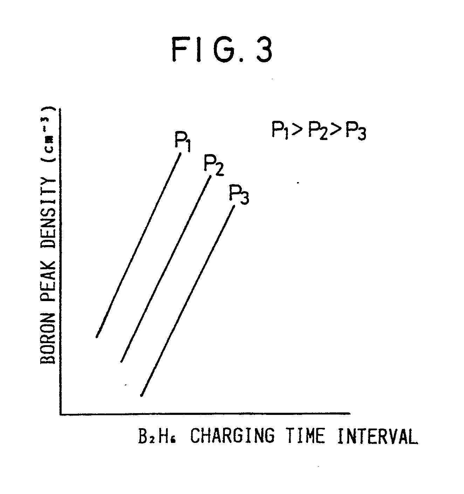

Fig. 3 is a graph showing the dependency of the doped boron peak density on the diborane charging time interval while the diborane charging pressure is set as a parameter. As shown in the Fig. 3 graph, the greater the charging pressure of diborane gas, the greater the amount of adsorbed boron, thereby increasing the peak density of the doped boron. Further, the longer the charging time interval of the diborane gas, the more the amount of adsorbed boron, thereby increasing the peak density of the doped boron. Therefore, by suitably setting the charging pressure and interval of the diborane, the boron peak density can be desirably controlled in the impurity diffusion layer. Consequently, the thus obtained boron diffusion layer can be applied for various uses.

As understood from the above description, the inventive method is characterized basically in that a semiconductor trench wall is chemically activated, and then an adsorption layer composed of an impurity element acting as a dopant for the semiconductor material is formed on the activated surface of the trench wall, and thereafter the impurity doping is effected into the semiconductor trench wall from an impurity diffusion source in the form of the adsorption layer. According to the inventors' study, it is found that an adsorption layer is not formed substantially on an inactive surface covered by the oxide film in contrast to the active surface, or the adsorbed impurity may remain on the inactive surface only one-tenth or less of that adsorbed on the active surface. Particularly, it is quite important to remove an inert film such as a natural oxide film when boron adsorbs on a silicon surface.

Besides diborane gas, doping of the P type impurity can be effected to the trench wall of silicon semiconductor substrate by using various source gases of compound composed of VI-group elements such as trimethyl gallium (TMG) and trichloroboron ( $BCl_3$). On the other hand, doping of the N type impurity can be effected to the trench wall of silicon semiconductor substrate by using various source gases such as arsine ( $AsH_3$), phosphorus trichloride ( $PCl_3$), antimony pentachloride ( $SbCl_5$) and phosphine ($PH_3$).

The substrate temperature should be preferably set in the range from $800°C$ to $1200°C$ dependently on the background pressure and ambient gas species for effecting cleaning treatment of the semiconductor trench wall. The substrate temperature should be preferably set in the range from $400°C$ to $950°C$ for carrying out the adsorption treatment.

It can be expedient to provide an under-coating in the form of an exitaxial silicon film rather than directly forming an impurity adsorption film on the activated trench wall of the semiconductor substrate. Otherwise, a silicon single crystal film may be formed on the impurity adsorption film by means of epitaxial growth method. Further, an impurity adsorption film and a silicon single crystal film may be superposed with one another so as to form an impurity diffusion layer. In this way, the silicon single crystal film is interposed so as to advantageously facilitate activation of the impurity. Moreover, the impurity adsorption film and the silicon single crystal film are superposed repeatedly so as to suitably control the thickness of the impurity diffusion layer. In addition, adsorption and diffusion of the impurity may be repeatedly carried out to form an impurity diffusion layer having desired impurity concentration, junction depth and impurity profile.

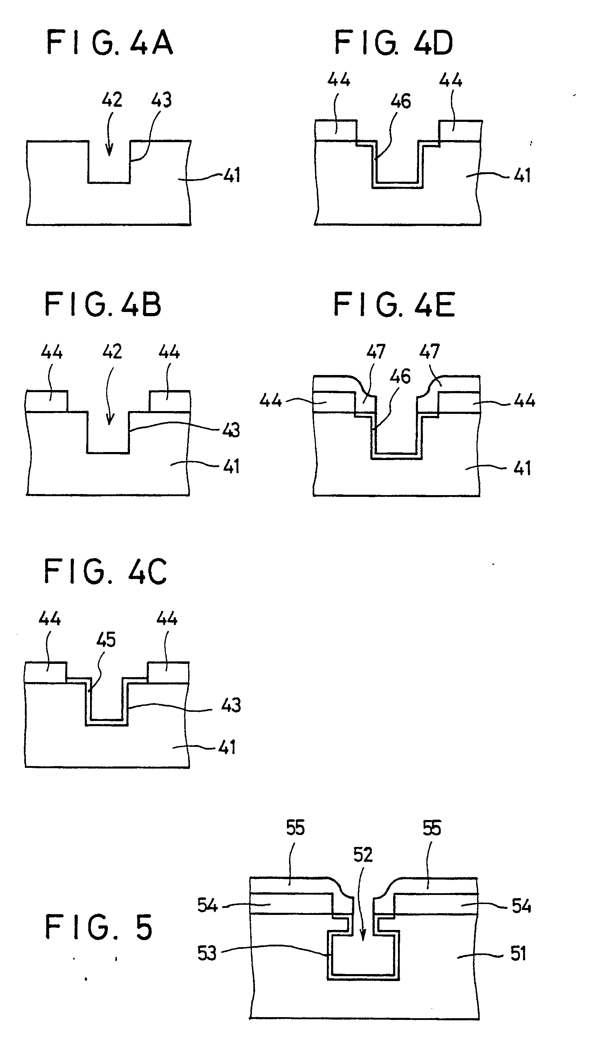

Hereinafter, the description is given for several applications of the inventive method to various semiconductor trench devices. Figs. 4A-4E are a process step diagram showing the method of producing a trench resistive element according to the inventive impurity doping method. In the Fig. 4A step, a semiconductor substrate 41 is composed of silicon, and a trench 42 is formed thereon, having an inner wall 43. The formation of trench 42 can be carried out, for example, by reactive ion etching.

In the Fig. 4B step, an insulating film 44 is formed on the substrate along edges of the trench 42 so as to mask a semiconductor region other than that to be doped with impurity. The insulating film 44 is provided by depositing a silicon oxide film or silicon nitride film, for example, by means of chemical vapor deposition method.

In the Fig. 4C step, cleaning treatment is carried out to exposed surface areas of the trench inner wall 43 and silicon substrate 41 so as to remove an inert film to thereby expose an active surface. Subsequently, diborane gas is applied to the active surface to selectively form an impurity adsorption film 45 containing boron. The adsorption of the impurity film 45 is chemically effected so that the impurity film 45 is deposited along the exposed surface areas of the trench inner wall 43 and silicon substrate 41 in uniform thickness.

In the Fig. 4D step, the substrate 41 is heated so that the impurity boron is diffused uniformly from the adsorption film 45 into the trench inner wall and the exposed surface of silicon substrate to thereby form an impurity diffusion layer 46. This impurity diffusion layer 46 is of $P^+$ type and has a desired resistivity by controlling the amount of adsorption of the impurity boron. Further, the impurity diffusion layer 46 is uniformly and continuously formed along the trench wall 43 to provide an excellent resistive layer.

Lastly in the Fig. 4E step, a pair of electrode layers 47 are formed opposite sides of the trench to form a so-called trench resistor. According to this embodiment, the resistor can be formed in the trench so as to facilitate miniaturization of a semiconductor device. If a resistive layer is formed on the trench wall by means of the conventional predeposition technology, there would be caused practical drawbacks such as cutting of the resistive film and variation of the resistive layer thickness.

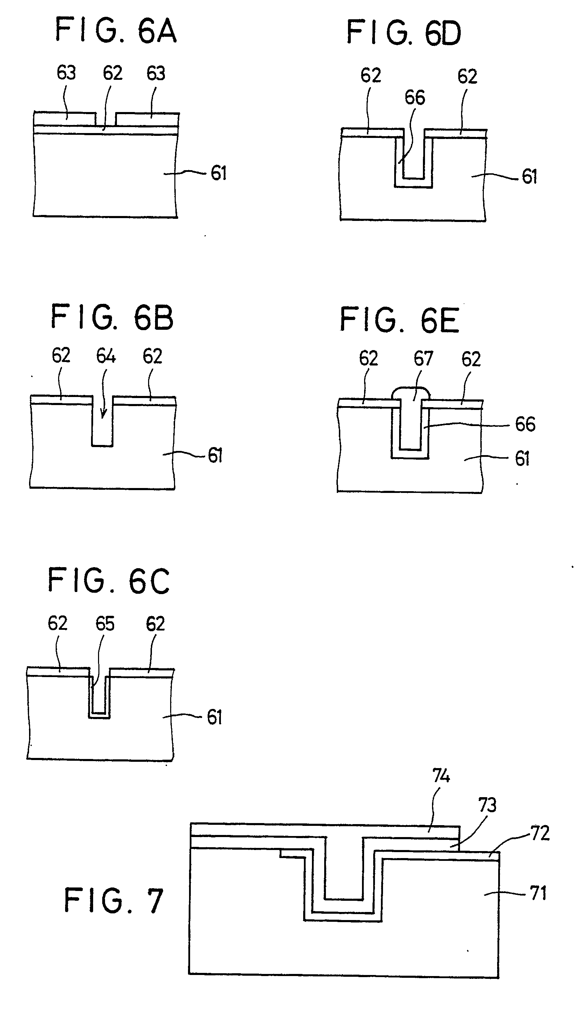

Fig. 5 shows another type of the trench resistor produced by the inventive impurity doping method. As shown in the figure, the trench resistor has a cavity 52 formed in a surface of a silicon semiconductor substrate 51. This cavity 52 has an upper neck portion and a lower enlarged portion so as to three-dimensionally and more efficiently use the semiconductor substrate area. An impurity diffusion layer 53 is formed along an inner wall of the cavity 52. A pair of electrode layers 55 are formed on opposite sides of the cavity 52 through an insulating film 54. These pair of electrodes 55 are connected at their end portions to the impurity diffusion layer 53 to constitute a trench resistor.

Figs. 6A-6E show a fabrication step diagram of a so-called trench device isolation region formed by the inventive impurity doping method. In the Fig. 6A step, a semiconductor substrate 61 composed of silicon is formed thereon with an insulating layer 62, which is composed of a silicon oxide layer or silicon nitride layer. The insulating layer 62 is coated by a resist film 63. The resist film 63 is etched with a predetermined pattern to remove a part thereof. This partly removed portion defines a device separation region.

In the Fig. 6B step, reactive ion etching is carried out through the resist film 63 to form a trench 64 in the substrate 61. Subsequently, the resist film 63 is removed by $H_2SO_4$ or $HNO_3$ or dry removing.

Then in the Fig. 6C step, an impurity adsorption film 65 of boron is selectively formed only on the trench inner wall. As described before, this boron adsorption treatment is carried out by applying diborane gas to the substrate 61 while heating the same.

In the Fig. 6D step, the substrate 61 is annealed so that boron atoms contained in the impurity adsorption film 65 are diffused into the semiconductor substrate 61 through the trench inner surface and are activated in the substrate. Consequently, a P type of impurity diffusion layer 66 is formed at relatively high concentration. This impurity diffusion layer 66 is provided to uniformly and completely cover the trench.

Lastly in the Fig. 6E step, the trench 64 is filled with an oxide layer 67, thereby completing a trench device isolation region. This trench device isolation region has a double layer structure composed of the filled oxide layer 67 and the impurity diffusion layer 66. Namely, the impurity diffusion layer 66 of high density P type is interposed between the semiconductor substrate 61 and the oxide layer 67 so as to efficiently ensure the isolation of adjacent device. Stated otherwise, the impurity diffusion layer 66 functions to avoid inversion of the semiconductor layer in the vicinity of the boundary to thereby significantly raise a threshold voltage of the trench isolation region.

Finally, Fig. 7 shows a trench capacitor fabricated according to the inventive impurity doping method. As shown in the figure, the trench capacitor is formed in a silicon semiconductor substrate 71 of the N type. The substrate 71 has therein a trench, and a $P^+$ type of electrode layer 72 is formed along an inner wall of the trench. This electrode layer 72 is formed according to the inventive impurity doping method in the form of a $P^+$ type impurity diffusion layer which contains boron. A dielectric layer 73 is formed along the electrode layer 72. This dielectric layer 73 is deposited by chemical vapor deposition of silicon dioxide. Another electrode layer 74 is formed on the dielectric layer 73. This electrode layer 74 is provided by depositing a polysilicon layer and by doping heavily an impurity into the polysilicon layer. According to this embodiment, the trench capacitor can be easily formed in the surface portion of the semiconductor substrate, thereby improving integration density of a semiconductor device.

As described above, according to the invention, an impurity diffusion layer can be formed uniformly and continuously along an inner wall of a trench formed in a surface portion of a semiconductor substrate by sequence of the cleaning treatment of the inner wall, the impurity adsorption treatment and the diffusion treatment. Further, impurity density and junction depth between the diffusion layer and the silicon substrate can be easily controlled in the impurity diffusion layer, so that the thus obtained impurity diffusion layer can be applied advantageously to various uses.

## Claims

1. A method of doping an impurity comprising:
   first step of forming a cavity in a surface portion of a semiconductor substrate to provide an inner wall in the semiconductor substrate;
   second step of removing an inert film from a surface of the inner wall to expose an active surface;
   third step of applying to the active surface a gas having an impurity component to adsorb an impurity component on the active surface to thereby form an impurity film; and
   fourth step of heating the semiconductor substrate to diffuse the impurity component from the impurity film into the inner wall of the cavity and to activate the impurity component.

2. A method according to claim 1; wherein the third step comprises applying a diborane gas containing an impurity component of boron to an inner wall of a cavity formed in a silicon substrate while heating the substrate to form a boron impurity film.

3. A method according to claim 1; wherein the third and fourth steps are carried out to form a resistive layer along the inner wall of the cavity of a trench shape to produce a trench resistor.

4. A method according to claim 1; wherein the third and fourth steps are carried out to form one electrode layer along the inner wall of the cavity of a trench shape; and including the steps of forming a dielectric layer on said one electrode layer, and forming another electrode layer on the dielectric layer to thereby form a trench capacitor.

5. A method according to claim 1; wherein the third and fourth steps are carried out to form an impurity diffusion layer along the inner wall of the cavity of a trench shape; and including the step of filling the cavity with an insulating film to thereby form a trench device isolation region.

# FIG.1A

# FIG.1B

# FIG.1C

# FIG.1D

# FIG. 2

# F I G. 3

$P_1 > P_2 > P_3$

BORON PEAK DENSITY ($cm^{-3}$)

$P_1$
$P_2$
$P_3$

$B_2H_6$ CHARGING TIME INTERVAL

# FIG. 4A

# FIG. 4D

# FIG. 4B

# FIG. 4E

# FIG. 4C

# FIG. 5

# FIG. 6A

# FIG. 6D

# FIG. 6B

# FIG. 6E

# FIG. 6C

# FIG. 7